(19) Europäisches Patentamt
European Patent Office
Office européen des brevets

(11) EP 0 631 377 B1

(12) # EUROPÄISCHE PATENTSCHRIFT

(45) Veröffentlichungstag und Bekanntmachung des Hinweises auf die Patenterteilung:
**08.09.1999 Patentblatt 1999/36**

(51) Int Cl.$^6$: **H03C 3/00**

(21) Anmeldenummer: **94108902.1**

(22) Anmeldetag: **10.06.1994**

(54) **Verfahren zur Frequenzmodulation**

Method for frequency modulation

Procédé de modulation de fréquence

(84) Benannte Vertragsstaaten:
**AT CH DE ES FR GB IT LI NL**

(30) Priorität: **24.06.1993 DE 4321000**

(43) Veröffentlichungstag der Anmeldung:
**28.12.1994 Patentblatt 1994/52**

(73) Patentinhaber: **ROBERT BOSCH GMBH**
**70442 Stuttgart (DE)**

(72) Erfinder: **Göckler, Heinz, Dr.**
**D-71522 Backnang (DE)**

(56) Entgegenhaltungen:

| | |
|---|---|
| **EP-A- 0 419 680** | **EP-A- 0 508 661** |
| **DE-A- 4 026 476** | **US-A- 5 111 163** |

- **PATENT ABSTRACTS OF JAPAN vol. 11 no. 249 (E-532) ,13.August 1987 & JP-A-62 062603 (MATSUSHITA ELECTRIC IND CO) 19.März 1987,**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 631 377 B1

## Beschreibung

Stand der Technik

Die Erfindung bezieht sich auf ein Verfahren zur FM-Modulation gemäß Oberbegriff des Patentanspruches 1.

Solche Verfahren sind bekannt, beispielsweise aus der Europäischen Patentanmeldung 508 661, die einen FM-Modulator beschreibt, der zur Erzeugung eines frequenzmodulierten Signales digitale Mittel in beschränkter Form benutzt, z.B. einen rückgekoppelten Phasenakkumulator zur Erzeugung eines digitalen frequenzmodulierten Signales und einen Trägeroszillator, welcher aus einer Tabelle Sinus- oder Cosinuswerte der Trägerschwigung ausliest. Dieser bekannte FM-Modulator gestattet zwar die beliebige Einstellung von Frequenzhub und Mittenfrequenz, und zwar unabhängig voneinander, weist aber eine Reihe von Nachteilen auf, wie z.B. Drift- und Alterungs-Probleme, nichtlineare Verzerrungen, das Erfordernis eines Abgleiches u.s.w., welche alle daher rühren, daß der wesentliche Schaltungsaufwand dieses Modulators auf analoge Weise realisiert ist.

Aus JP-A-62-062603 (Abstract) und EP-A-419 680 sind auch Beispiele für digitale Frequenzmodulatoren bekannt.

Der parallelen europäischen Patentanmeldung EP-A-631678 liegt die Aufgabe zugrunde, ein Verfahren der Eingangs genannten Art zur FM-Modulation eines digitalen Trägersignals mit einem digitalen NF-Signal anzugeben, welches die genannten Nachteile nicht aufweist.

Durch die volldigitale Realisierung des FM-Modulators gemäß der parallelen Patentanmeldung ergeben sich die Vorteile, daß Drift- und Alterungsprobleme entfallen, daß kein Abgleich erforderlich ist, wodurch personal- und zeitintensive Aufwände entfallen, daß eine volle Integrationsfähigkeit als VLSI- bzw. ASIC-Baustein möglich ist, daß nichtlineare Verzerrungen minimal sind, daß eine Anwendung sowohl in volldigitaler als auch in analoger bzw. halbanaloger Umgebung möglich ist, letztere durch eine Ausstattung am Ein- oder Ausgang mit Analog-/Digital- bzw. Digital-/Analog-Umsetzung.

Es folgt die Beschreibung der Erfindung anhand der Figuren. Vorüberlegungen zum Prinzip des erfindungsgemäßen Verfahrens werden anhand der Figur 1 erläutert, die das Blockschaltbild eines FM-Modulators, volldigital realisiert, zeigt. Die Figuren 2a bis 2e geben Spektren und Übertragungsfunktionen an einzelnen Punkten bzw. einzelner Bausteine der Figur 1 wieder. Anhand der Figuren 3 und 4 wird das erfindungsgemäße Verfahren erläutert. Die Figur 5 veranschaulicht die komplexe Faltung.

Die Signalquelle Q in Figur 1 liefert ein analoges, bandbegrenztes Signal $\alpha \cdot v(t)$, welches durch einen Analog-Digital-Umsetzer anschließend digitalisiert wird, oder unmittelbar ein digitales Signal $v(kT)\cdot\Delta f/f_A$ (wobei $T = 1/f_A$ das Abstastintervall ist), das nachfolgend einen Träger der Frequenz $f_C$ bzw. der FM-Mittenfrequenz $f_0$ (in der Zwischenfrequenzlage) in der Frequenz moduliert mit dem Frequenzhub $\Delta f$. Dem digitalen, modulierenden Signal v(kT) mit k = 0, 1, ... wird zunächst eine Konstante $f_0/f_A$ hinzu addiert, mit der die ausgangsseitig erwünschte Kanalmittenfrequenz $f_C = M \cdot f_A + f_0$ festgelegt wird, wobei M eine ganze Zahl ist. Damit ergibt sich die auf die Abtastfrequenz normierte Momentanfrequenz des FM-Signals in der Zwischenfrequenzlage um $f_0$ zu

$$\frac{f(k)}{f_A} = \frac{f_0}{f_A} + \frac{\Delta f}{f_A} . v(k) \qquad (1),$$

wobei der Term $k \cdot T$ abkürzend durch k, den laufenden Zeit- bzw. Abtastindex, ersetzt wurde. Die Größe $\Delta f$ ist der Frequenzhub, der unabhängig von $f_0$ wählbar ist und der angibt, um wieviel die Momentanfrequenz des modulierten FM-Signals f(k) maximal von der FM-Mittenfrequenz $f_0$ (das ist die Frequenz des unmodulierten Trägersignals in der Zwischenfrequenzlage abweichen kann, wenn ohne Einschräkung der Allgemeinheit

$$\max. \{ v(k) \} \equiv 1$$

gesetzt wird.

Aus (1) folgt die momentane Phase $\varphi$ (kT) des FM-Signals durch Integration, was im Digitalen durch den idealen Integrator, nämlich durch einen rückgekoppelten Akkumulator realisiert wird mit nachfolgender Multiplikation mit $2\pi$:

$$\varphi\ (kT) = 2\pi \sum_{\chi=0}^{k} [f_0/f_A + v(\chi) \cdot \Delta f/f_A]$$

$$= 2\pi\ kf_0/f_A + 2\pi\ \Delta\ f/f_A \sum_{\chi=0}^{k} v(\chi)$$

$$= \omega_0\ kT + \Delta\Omega\ T \sum_{\chi=0}^{k} v(\chi) \qquad (2)$$

Anschließend erfolgt die komplexe Trägererzeugung und -Umsetzung, wobei aus einer Tabelle das komplexwertige FM-Signal

$$\underline{g}(k) = e^{j\varphi(k)} = g_r(k) + jg_i(k)$$

$$= \cos[\varphi(k)] + j \sin[\varphi(k)] \qquad (3)$$

ausgelesen wird. Die komplexwertigen Signale sind in Figur 1 und Figur 2 durch Unterstreichung und in Figur 1 ihre Signalpfade durch Doppel-Striche bzw. Doppel-Pfeile und die Bausteine mit komplexwertigen Koeffizienten wie Filter, Tabellen u.s.w. mit doppelter Berandung gekennzeichnet. $j = \sqrt{-1}$, zuerst in Gleichung 3 verwendet, ist die Imaginäreinheit, die rechnerisch nur implizit zu berücksichtigen ist. Ein komplexwertiges Signal ist ein Signal, das aus zwei Komponenten, nämlich dem Real- und dem Imaginärteil zusammengesetzt ist. Das FM-Signal $\underline{g}(k)$ ist idealerweise nicht bandbegrenzt, weshalb es durch ein Filter F mit komplexen Koeffizienten so bandzubegrenzen ist, daß die Systemanforderungen bezüglich Nachbarkanalstörungen eingehalten werden (bei UKW Bandbreite 300 kHz) : Das Ergebnis am Filterausgang $\underline{d}(k)$. Danach folgt ein Interpolations-Filter CIPF mit komplexen Koeffizienten, welches die Abtastfrequenz $f_A$ um den erforderlichen Faktor L erhöht, so daß am Filterausgang nur das gewünschte FM-Signal y (kT/L) um

$$f_C/f_A = M + f_0/f_A \qquad (4)$$

erscheint im Bereich $[0, L \cdot f_A]$. Das bedeutet, daß das komplexe Interpolations-Filter CIPF um $f_C$ einen Durchlaßbereich aufweisen und bei bezüglich $f_A$ periodischen Spektralanteilen sperren muß.

Wird nun im System ein nur reelles FM-Signal benötigt, so wird lediglich der Realteil oder der Imagninärteil weiter verwendet. Gegebenenfalls kann eine Digital-Analog-Umsetzung erforderlich sein, der dann üblicherweise ein analoges Glättungs-Filter ABP (meistens Tiefpaß, aber auch Bandpaß) folgt.

Die Funktionsweise des beschriebenen FM-Modulators wird nun im Frequenzbereich spektralmäßig erläutert. In den Figuren 2a bis 2e sind die Spektren jeweils mit den entsprechenden Großbuchstaben bezeichnet und beispielhaft Werte für M = 3 und L = 4 angesetzt.

Durch die Fouriertransformation sind Übertragungsfunktion und Impulsantwort bzw. Frequenz- und Zeitbereich miteinander verbunden:

$$\underline{G}(e^{j\Omega}) \bullet\!\!-\!\!\circ\ \underline{g}(kT) \qquad (5)$$

Am Ausgang des komplexen Trägeroszillators COSZ entsteht das Spektrum $\underline{G}(e^{J\Omega})$, siehe Figur 2a, das mit Hilfe der Übertragungsfunktion $\underline{H}_F$ des Filters F auf die zulässige Bandbreite begrenzt wird zu $\underline{D}(e^{J\Omega})$, siehe Figur 2b. Falls die FM-Mittenfrequenz (in der Zwischenfrequenzlage) $f_0 = 0$ ist, sind Filterfunktion und Spektrum bezüglich f = 0

bzw. bezüglich $f_A$ nichtsymmetrisch (Eigenschaften komplexwertiger Signale). Das Interpolationsfilter CIPF selektiert den gewünschten Spektralanteil um $f_C$, was möglich ist, da es auf die erhöhte Abtastfrequenz $L \cdot f_A = 4f_A$ bezogen ist (siehe $\underline{D}$ am Eingang von CIPF, Figur 2b, und $\underline{Y}$ am Ausgang von CIPF, Figur 2c).

Wird nur der Real- oder Imaginärteil weiterverwendet, so ergibt sich das Spektrum Y gemäß Figur 2d. Dieses Spektrum Y ist mit den gezeichneten Spektren symmetrisch sowohl bezüglich f = 0 als auch $f_A'/2 = 2f_A$, da es sich hier im Unterschied zur Figur 2a bis 2c um ein reelles Signal handelt. Dasselbe gilt auch für das analoge Signal y(t) beziehungsweise für sein Spektrum |Y| nach einer Digital-Analog-Umsetzung DAU mit nachfolgendem Glättungs-Filter ABP, siehe Figur 2e.

Wie aus den bisherigen Ausführungen und auch aus Figur 2a ersichtlich, ist die Bandbreite des FM-Signals $\underline{g}$(k) und auch des bandbegrenzten FM-Signals d(k) deutlich größer als die des modulierenden Signals v(k), beispielsweise bei UKW-Stereo 300 kHz zu 60 kHz.

Daher kann das modulierende Digital-Signal v(kT) auch mit niedrigerer Abtastfrequenz $f_A/P$ angeliefert werden mit

$$v' = v(kPT) \tag{6},$$

wobei P aus Aufwandsgründen, aber nicht zwingend, ganzzahlig gewählt werden sollte.

In diesem Fall ist an beliebiger Stelle zwischen Quelle Q bzw. nach dem Analog-Digital-Umsetzer ADU und dem komplexen Trägeroszillator COSZ die Abtastfrequenz mittels eines Interpolations-Filters oder durch eine Kaskade von mehreren solchen Filtern um den Faktor P zu erhöhen.

Die Multiplikation $2\pi$ vor dem komplexen Trägeroszillator COSZ gemäß Figur 1 kann entfallen, wenn die Adressen für die COSZ-Tabelle entsprechend normiert werden: Adressraum [0, 1] Modulo 1 statt [0, $2\pi$] Modulo $2\pi$.

Die Tabelle des komplexen Trägeroszillators COSZ kann in folgenden Varianten aufgebaut sein:

1. Zwei Tabellen gleichen Inhalts werden mit unterschiedlichen Adressen angesteuert, wobei die Adressendifferenz $\Delta\varphi = \pi/2$ ist, und gleichzeitig parallel ausgelesen.
2. Es gibt eine gemeinsame Tabelle für Real- und Imaginärteil; diese Tabelle wird für Real- und Imaginärteil sequentiell angesteuert und ausgelesen.
3. Es gibt eine Tabelle für den Realteil und eine Tabelle für den Imaginärteil, beide sind so angeordnet, daß für eine Adresse der Realteil aus der einen und der Imaginärteil aus der anderen Tabelle gleichzeitig und parallel geliefert werden.

Die Abtastwerte der komplexen Schwingung gemäß Gl. (3) lassen sich aber auch jeweils aktuell berechnen. z.B. mit Hilfe ausreichend genauer Reihenentwicklungen.

Die Filter mit komplexen Koeffizienten lassen sich im allgemeinsten Fall mit 4 Teilfiltern mit jeweils reellen und paarweise gleichen Koeffizienten realisieren, siehe Figur 5, wodurch der Aufwand ebenfalls erheblich gesenkt wird. Interpolations-Filter, deren Ausgangs-Abtast-Frequenz für verfügbare Bausteine sehr och oder zu hoch ist, so daß die Realisierung Schwierigkeiten bereitet oder überhaupt nicht möglich ist, lassen sich als sogenannte Polyphasenfilter-Netzwerke realisieren, siehe hierzu Deutsches Patent 40 26 476.9.

Die komplexen Filter F und CIPF können zu einem einzigen komplexwertigen Filter zusammengefaßt werden, was ebenfalls eine Aufwandsverminderung sein kann.

Aufgabe der vorliegenden Erfindung ist es, das oben beschriebene Verfahren dahingehend zu verbessern, daß es bei vermindertem Aufwand und unter Umgehung technologischer Grenzen dieselben Ergebnisse liefert.

Die Lösung erfolgt durch die Merkmale des Anspruches 1; vorteilhafte Ausgestaltungen ergeben sich durch die Unteransprüche.

Das erfindungsgemäße Verfahren geht aus einer Abwandlung der Figur 1 nach Figur 3 hervor. Figur 3 gibt das Blockschaltbild für einen Teil des abgewandelten FM-Modulators wieder. Die eingangsseitige Verarbeitung des modulierenden NF-Signals zur Momentanphase $\varphi$(kT) des FM-modulierten Signals nach Gleichung (2), ob mit oder ohne Multiplikation mit $2\pi$, ist identisch mit Figur 1. Es ist nur der Unterschied zu vermerken, daß $f_0 \equiv 0$ angenommen wird. Damit liegt die Schwerpunkts- oder Zwischenfrequenz von $\underline{g}$(k) und $\underline{d}$(k) bei $f_0 = 0$, weshalb das Bandbegrenzungsfilter F nunmehr bezüglich $f_0 = 0$ einen symmetrischen Frequenzgang aufweist. Damit sind seine Koeffizienten reell; zwei Teilfilter des üblicherweise aus vier Teilfiltern bestehenden komplexwertigen Filters (siehe Fig. 5) entfallen, was etwa einer Aufwandshalbierung entspricht.

Dasselbe gilt auch für das komplexe Interpolationsfilter CIPF. Beide Filter F und CIPF bestehen damit aus jeweils zwei identischen Tiefpässen TP1 bzw. TP2, die jeweils im Realzweig und im Imaginärzweig eingesetzt sind.

Eine Frequenzverschiebung des komplexwertigen Ausgangssignals $\underline{x}$ (kT/L), welches bei $f_0 = 0$ zentriert ist, läßt sich durch eine komplexe Multiplikation entsprechend Fig. 5 durchführen. Anstelle der Filterblöcke wird multipliziert

mit dem Wert $e^{J2\pi kf_C/(f_A \cdot L)}$ und zwar in vier reellen Multiplikationen entsprechend Gl. (3). Die komplexen Abtastwerte der Trägerschwingung der Frequenz $f_C$ werden entsprechend dem komplexen Oszillator COSZ aus Tabellen ausgelesen oder aktuell berechnet.

Weitere Vereinfachungen zu Aufwandsverminderung lassen sich beim Interpolationsfilter erreichen, wenn anstatt einer einzigen Stufe mit dem Interpolationsfaktor L in einer Kaskade von I Teilfiltern mit den einzelnen Teilinterpolationsfaktoren $L_i$ interpoliert und gefiltert wird. Dabei wird der Faktor L gemäß

$$L = \prod_{i=1}^{I} L_i \qquad (7)$$

in I ganzzahlige Teilfaktoren zerlegt, wobei die Faktoren $L_i$ zwar nicht zwingend ganzzahlig sein müssen, aber sinnvoll so festgelegt werden; soweit zur Fig. 3.

Eine Weiterbildung des erfindungsgemäßen Verfahrens ist aus Fig. 4 entnehmbar.

Die Figur 4 gibt einen Teil des FM-Modulators als Blockschaltbild wieder und stellt eine Variante der Figur 3 dar. Es ist ein Ausführungsbeispiel, das besonders aufwandsgünstig arbeitet und technologische Grenzen (zu hohe Operationsraten) umgeht.

Da die Mittenfrequenz bzw. die Schwerpunktsfrequenz des FM-Modulationssignals in der Zwischenfrequenzlage bei $f_0 = 0$ liegt, können die Tiefpaßfilter TP1 und TP2 zur Bandbegrenzung bzw. ersten Interpolation um den Faktor $L_1$ als reellwertige Filter realisiert werden, welche identisch im Realzweig und im Imaginärzweig hinter dem komplexen Trägerfrequenzoszillator COSZ liegen. Die Ausgänge der beiden zweiten Tiefpässe $TP_2$, also Real- und Imaginärteil, werden zur Frequenzverschiebung einer komplexen Multiplikation mit dem Faktor $e^{j2\pi kf_1/(f_A \cdot L_1)}$ zugeführt. Die beiden Teil-Interpolationsfaktoren $L_1$ und $L_2$ werden so gewählt, daß die soeben beschriebene Frequenzverschiebung bei der Abtastfrequenz $f_A \cdot L_1$ technologisch problemlos durchgeführt werden kann. Der Frequenzverschiebung schließt sich eine letzte Interpolationsstufe mit dem komplexen Interpolationsfilter CIPF und dem Interpolationsfaktor $L_2$ an.

Zur Vereinfachung der Handhabung der Frequenzverschiebung gemäß Figur 4 läßt sich mit Gleichung (4) $f_1$ durch $f_C$ ersetzen: Es gilt gemäß Gleichung (4) $f_C = M_1 \cdot L_1 \cdot f_A + f_0$. Da $M_1$ ganzzahlig ist, folgt für die Abtastwerte der Mischerfrequenz $e^{j2\pi kf_1/(L_1 f_A)} = e^{j2\pi kf_C/(L_1 f_A)}/e^{j2\pi kM_1} = e^{j2\pi kf_C/(L_1 f_A)}$.

**Patentansprüche**

1. Verfahren zur FM-Modulation eines digitalen Trägersignals mit einem digitalen NF-Signal mittels eines rückgekoppelten Phasenakkumulators und eines Trägeroszillators, welcher numerisch gesteuert die Abtastwerte der modulierten FM-Schwingung bzw. des FM-Signals erzeugt, dadurch gekennzeichnet,

   daß durch den Trägeroszillator (COSZ), der mit einer Abtastrate $f_A = 1/T$ arbeitet, ein komplexwertiges FM-Zwischenfrequenzsignal ($\underline{g}(kT)$) erzeugt wird, wobei die Zwischenfrequenz des nichtmodulierten Trägers $f_0 = 0$ bzw. die Trägerfrequenz $f_C = M \cdot f_A$ mit der ganzen Zahl M>1 ist,

   daß dieses komplexwertige Signal anschließend mittels zweier identischer reeller Tiefpaßfilter (F, TP1) bandbegrenzt wird,

   daß anschließend Real- und Imaginärteil jeweils interpoliert werden und mittels zweier zweiter identischer reellwertiger Tiefpässe (TP2) zur Erhöhung der Abtastfrequenz $f_A$ um einen ersten Interpolations-Faktor L gefiltert werden,

   daß das gefilterte komplexe Signal durch Multiplikation mit $e^{j2\pi kf_C/(Lf_A)}$ in eine Frequenzlage um eine Frequenz $f_C$ gehoben wird.

2. Verfahren nach Anspruch 1, dadurch gekennzeichnet, daß der erste Interpolations-Faktor ein Interpolations-Teilfaktor $L_1$ ist, daß das gefilterte komplexe Signal $\underline{x}_1(kT/L_1)$ durch Multiplikation mit $e^{j2\pi kf_C/(L_1 f_A)}$ in die gewünschte Frequenzlage um die Trägerfrequenz $f_C$ gehoben wird und daß die Abtastfrequenz des frequenzverschobenen komplexen Signals mittels eines komplexwertigen Interpolationsfilters (CIPF) um einen zweiten Interpolations-Teilfaktor $L_2$ zu $\underline{y}(kT/L) = \underline{y}\,[kT/(L_1 L_2)]$ interpoliert wird.

**3.** Verfahren nach einem der vorhergehenden Ansprüche, dadurch gekennzeichnet, daß der erste Interpolationsfaktor L eine ganze Zahl ist.

**4.** Verfahren nach Anspruch 2, dadurch gekennzeichnet, daß die Interpolations-Teilfaktoren $L_i$ ganze Zahlen sind.

**5.** Verfahren nach einem der vorhergehenden Ansprüche, dadurch gekennzeichnet, daß die Bandbegrenzung des FM-Signals auf die UKW-Bandbreite von 300 kHz erfolgt.

**6.** Verfahren nach einem der vorhergehenden Ansprüche, dadurch gekennzeichnet, daß aus dem interpolierten Ausgangssignal ($\underline{y}(kT/L)$) durch Berechnung des Real- oder Imaginärteils ein reellwertiges FM-Signal ($y(kT/L)$) erzeugt wird.

**7.** Verfahren nach Anspruch 6, dadurch gekennzeichnet, daß das reellwertige FM-Signal digital-analog umgesetzt wird.

**8.** Verfahren nach Anspruch 7, dadurch gekennzeichnet, daß das analoge FM-Signal mittels eines analogen Glättungsfilters (ABP bzw. ATP) geglättet wird.

**9.** Verfahren nach einem der vorhergehenden Ansprüche, dadurch gekennzeichnet, daß auf dem Signalpfad des NF-Signals an einer beliebigen Stelle vor dem komplexen Trägeroszillator (COSZ) eine Multiplikation mit $2\pi$ erfolgt.

**10.** Verfahren nach einem der vorhergehenden Ansprüche, dadurch gekennzeichnet, daß die Abtastwerte der modulierten FM-Schwingung aus einer Tabelle ausgelesen werden.

**11.** Verfahren nach Anspruch 10, dadurch gekennzeichnet, daß die Tabelle des komplexen Trägeroszillators (COSZ) zwei Teile mit gleichem Inhalt aber mit unterschiedlichen Adressen enthält, welche zur Lieferung des Real- und Imaginärteils des komplexwertigen FM-Zwischenfrequenzsignals gleichzeitig angesteuert und ausgelesen werden.

**12.** Verfahren nach Anspruch 10, dadurch gekennzeichnet, daß die Tabelle des komplexen Trägeroszillators (COSZ) aus einem Sinus- und einem Cosinusteil besteht, die unter der gleichen Adresse jeweils gleichzeitig angesteuert und ausgelesen werden.

**13.** Verfahren nach Anspruch 10, dadurch gekennzeichnet, daß die Tabelle des komplexen Trägeroszillators (COSZ) nur eine einzige Wertetabelle für Real- und Imagninärteil umfaßt, die sequentiell angesteuert und ausgelesen werden.

**14.** Verfahren nach einem der Ansprüche 1 bis 9, dadurch gekennzeichnet, daß die aktuellen Abtastwerte des komplexwertigen FM-Zwischenfrequenzsignals jeweils mittels eines speziellen Rechenwerkes berechnet werden.

**15.** Verfahren nach einem der Ansprüche 2 bis 14, dadurch gekennzeichnet, daß die Tiefpaßfilterung des Komplexwertigen FM-Zwischenfrequenzsignals des komplexen Trägeroszillators (COSZ) in zwei Kaskadenstufen jeweils mit reellwertigen Tiefpässen (TP1 und TP2) erfolgt, daß die Interpolation des komplexwertigen Ausgangssignals ebenfalls in zwei Kaskadenstufen mit den Teilinterpolationsfaktoren $L_1$ und $L_2$ erfolgt und daß zur Frequenzverschiebung die komplexe Multiplikation mit $e^{j2\pi k f_C/(f_A L_1)}$ zwischen den bieden Interpolationsstufen erfolgt.

**16.** Verfahren nach Anspriuch 15, dadurch gekennzeichnet, daß die letzte Interpolationsstufe durch ein komplexes Interpolationsfilter (CIPF) mit dem Interpolationsfaktor $L_2$ realisiert ist.

**17.** Verfahren nach einem der vorhergehenden Ansprüche, dadurch gekennzeichnet, daß die Interpolationsfilter (IPF, CIPF) als Polyphasennetzwerke realisiert sind.

**18.** Verfahren nach einem der vorhergehenden Ansprüche, dadurch gekennzeichnet, daß die Filter als FIR-Filter realisiert sind.

## Claims

1. Method for frequency modulation of a digital carrier signal with a digital AF signal by means of a phase accumulator with feedback and a carrier oscillator which, numerically controlled, produces the samples of the modulated FM oscillation or of the FM signal, characterized

   in that a complex FM intermediate-frequency signal ($\underline{g}$ (kT)) is produced by a carrier oscillator (COSZ) which operates at a sampling rate of $f_A = 1/T$, in which case the intermediate frequency of the unmodulated carrier is $f_0 = 0$ and the carrier frequency is $f_C = M \cdot f_A$, where M is an integer greater than 1,
   in that this complex signal is subsequently bandlimited by means of two identical real low-pass filters (F, TP1),
   in that the real part and the imaginary part are then each interpolated and are filtered by means of two second identical real-value low-pass filters (TP2) in order to increase the sampling frequency $f_A$ by a first interpolation factor L,
   in that the filtered complex signal is raised by a frequency $f_C$ to a frequency by multiplication by $e^{j2\pi k f_C/(L f_A)}$.

2. Method according to Claim 1, characterized in that the first interpolation factor is an interpolation sub-factor $L_1$, in that the filtered complex signal $\underline{x}_1(kT/L_1)$ is raised by the carrier frequency $f_c$ to the desired frequency by multiplication by $e^{j2\pi k f_C/(L_1 f_A)}$, and in that the sampling frequency of the frequency-shifted complex signal is interpolated by means of a complex interpolation filter (CIPF) by a second interpolation sub-factor $L_2$ to give $\underline{y}(kT/L) = \underline{y}[kT/(L_1 L_2)]$.

3. Method according to one of the preceding claims, characterized in that the first interpolation factor L is an integer.

4. Method according to Claim 2, characterized in that the interpolation sub-factors $L_i$ are integers.

5. Method according to one of the preceding claims, characterized in that the band-limiting of the FM signal is carried out to the radio VHF bandwidth of 300 kHz.

6. Method according to one of the preceding claims, characterized in that a real FM signal (y(kT/L)) is produced from the interpolated output signal ($\underline{y}$(kT/L)) by calculating the real part or the imaginary part.

7. Method according to Claim 6, characterized in that the real FM signal is digital/analogue converted.

8. Method according to Claim 7, characterized in that the analogue FM signal is smoothed by means of an analogue smoothing filter (ABP or ATP).

9. Method according to one of the preceding claims, characterized in that multiplication by $2\pi$ is carried out at any desired point upstream of the complex carrier oscillator (COSZ) on the signal path of the AF signal.

10. Method according to one of the preceding claims, characterized in that the samples of the modulated FM oscillation are read from a table.

11. Method according to Claim 10, characterized in that the table for the complex carrier oscillator (COSZ) contains two parts with the same contents but with different addresses, which are actuated and read from simultaneously in order to provide the real part and the imaginary part of the complex FM intermediate-frequency signal.

12. Method according to Claim 10, characterized in that the table for the complex carrier oscillator (COSZ) comprises a sine part and a cosine part, which are each actuated and read from simultaneously, at the same address.

13. Method according to Claim 10, characterized in that the table for the complex carrier oscillator (COSZ) comprises a single value table for the real part and imaginary part, which are actuated and read from sequentially.

14. Method according to one of Claims 1 to 9, characterized in that the instantaneous samples of the complex FM intermediate-frequency signal are each calculated by means of a special arithmetic unit.

15. Method according to one of Claims 2 to 14, characterized in that the low-pass filtering of the complex FM intermediate-frequency signal of the complex carrier oscillator (COSZ) is carried out in two cascade stages, each having real-value low-pass filters (TP1 and TP2), in that the interpolation of the complex output signal is likewise carried

out in two cascade stages using the partial interpolation factors $L_1$ and $L_2$, and in that the complex multiplication by $e^{j2\pi kf_C/(f_A L_1)}$ for frequency shifting is carried out between the two interpolation stages.

**16.** Method according to Claim 15, characterized in that the last interpolation stage is a complex-value interpolation filter (CIPF) using the interpolation factor $L_2$.

**17.** Method according to one of the preceding claims, characterized in that the interpolation filters (IPF, CIPF) are polyphase networks.

**18.** Method according to one of the preceding claims, characterized in that the filters are FIR filters.

**Revendications**

**1.** Procédé de modulation FM d'un signal de porteuse numérique par un signal BF numérique, à l'aide d'un accumulateur de phase à réaction et d'un oscillateur de porteuse commandés numériquement, pour générer les valeurs de détection de l'oscillation FM modulée ou du signal FM,
caractérisé en ce que
l'oscillateur de porteuse (COSZ) qui travaille à une fréquence de détection $f_A = 1/T$, génère un signal de fréquence intermédiaire FM, de valeur complexe ($\underline{g}(kT)$), la fréquence intermédiaire de la porteuse non modulée étant $f_O$ = O ou la fréquence de porteuse $f_C = M \cdot f_A$ avec un nombre entier M>1,

- ce signal de valeur complexe est alors limité en bande par deux filtres passe-bas, réels, identiques (F, TP1),
- puis, on interpole chaque fois la partie réelle et la partie imaginaire et on filtre à l'aide de deux filtres passe-bas (TP1) à seconde valeur réelle identique pour augmenter la fréquence de détection $f_A$ d'un premier coefficient d'interpolation L,
- on relève le signal complexe filtré par multiplication par $e^{j2\pi rk_C f/(Lf_A)}$, dans une position de fréquence autour d'une fréquence $f_C$.

**2.** Procédé selon la revendication 1,
caractérisé en ce que
le premier coefficient d'interpolation est un coefficient partiel d'interpolation $L_1$,

- le signal complexe filtré $\underline{x}_1(kT/L_1)$ est relevé par multiplication par $e^{j2\pi kf_C/(L_1 f_A)}$, à la position de fréquence souhaitée autour de la fréquence porteuse $f_C$, et
- la fréquence de détection du signal complexe décalé en fréquence est interpolée à l'aide d'un filtre d'interpolation de valeur complexe (CIPF) selon un second coefficient partiel d'interpolation $L_2$ pour donner $\underline{y}(kT/L) = \underline{y}\,[kT/(L_1L_2)]$.

**3.** Procédé selon l'une des revendications précédentes, caractérisé en ce que
le premier coefficient d'interpolation L est un nombre entier.

**4.** Procédé selon la revendication 2,
caractérisé en ce que
les coefficients partiels d'interpolation $L_i$ sont des nombres entiers.

**5.** Procédé selon l'une quelconque des revendications précédentes,
caractérisé en ce que
la limitation de bande du signal FM se fait à la largeur de bande FM de 300 kHz.

**6.** Procédé selon l'une quelconque des revendications précédentes,
caractérisé en ce qu'
à partir du signal de sortie interpolé ($\underline{y}(kT/L)$) on génère un signal FM à valeur réelle ($\underline{y}(kT/L)$) par calcul de la partie réelle et de la partie imaginaire.

**7.** Procédé selon la revendication 6,
caractérisé en ce qu'
on convertit le signal FM de valeur réelle par une conversion numérique/analogique.

**8.** Procédé selon la revendication 7,
caractérisé en ce qu'
on lisse le signal FM analogique à l'aide d'un filtre de lissage analogique (ABP, ATP).

**9.** Procédé selon l'une quelconque des revendications précédentes,
caractérisé en ce que
sur le chemin du signal BF en un point quelconque en amont de l'oscillateur de porteuse complexe (COSZ), on effectue une multiplication par $2\pi$.

**10.** Procédé selon l'une quelconque des revendications précédentes,
caractérisé en ce qu'
on extrait d'un tableau les valeurs de détection de l'oscillation FM modulée.

**11.** Procédé selon la revendication 10,
caractérisé en ce que
le tableau de l'oscillateur de porteuse à valeur complexe (COSZ) contient deux parties de même contenu mais ayant des adresses différentes qui sont commandées et lues simultanément pour fournir la partie réelle et la partie imaginaire du signal de fréquence intermédiaire FM à valeur complexe.

**12.** Procédé selon la revendication 10,
caractérisé en ce que
le tableau de l'oscillateur de porteuse complexe (COSZ) se compose d'une partie sinus et d'une partie cosinus qui sont commandées et lues simultanément chaque fois sous la même adresse.

**13.** Procédé selon la revendication 10,
caractérisé en ce que
le tableau de l'oscillateur à valeur complexe (COSZ) comprend seulement un unique tableau de valeurs pour la partie réelle et la partie imaginaire, ces valeurs étant commandées et lues séquentiellement.

**14.** Procédé selon l'une des revendications 1 à 9,
caractérisé en ce que
les valeurs de détection actuelles du signal de fréquence intermédiaire FM de valeur complexe, sont chaque fois calculées à l'aide d'un calculateur particulier.

**15.** Procédé selon l'une quelconque des revendications 2 à 14,
caractérisé en ce que
le filtrage passe-bas du signal de fréquence intermédiaire FM de valeur complexe de l'oscillateur de porteuse complexe (COSZ) se fait selon deux étages en cascade, chaque fois avec des filtres passe-bas de valeur réelle (TP1 et TP2),

- l'interpolation du signal de sortie de valeur complexe se fait également dans deux étages en cascade avec des coefficients d'interpolation partiels $L_1$, $L_2$ et,
- pour le décalage en fréquence, on multiplie par le coefficient $e^{j2\pi kfc/(f_A L_1)}$, entre les deux étages d'interpolation.

**16.** Procédé selon la revendication 15,
caractérisé en ce que
le dernier étage d'interpolation est réalisé par un filtre d'interpolation complexe (CIPF) avec un coefficient interpolation $L_2$.

**17.** Procédé selon l'une quelconque des revendications précédentes,
caractérisé en ce que
les filtres d'interpolation (IPF, CIPF) sont des réseaux polyphasés.

**18.** Procédé selon l'une quelconque des revendications précédentes,
caractérisé en ce que
les filtres sont des filtres FIR.

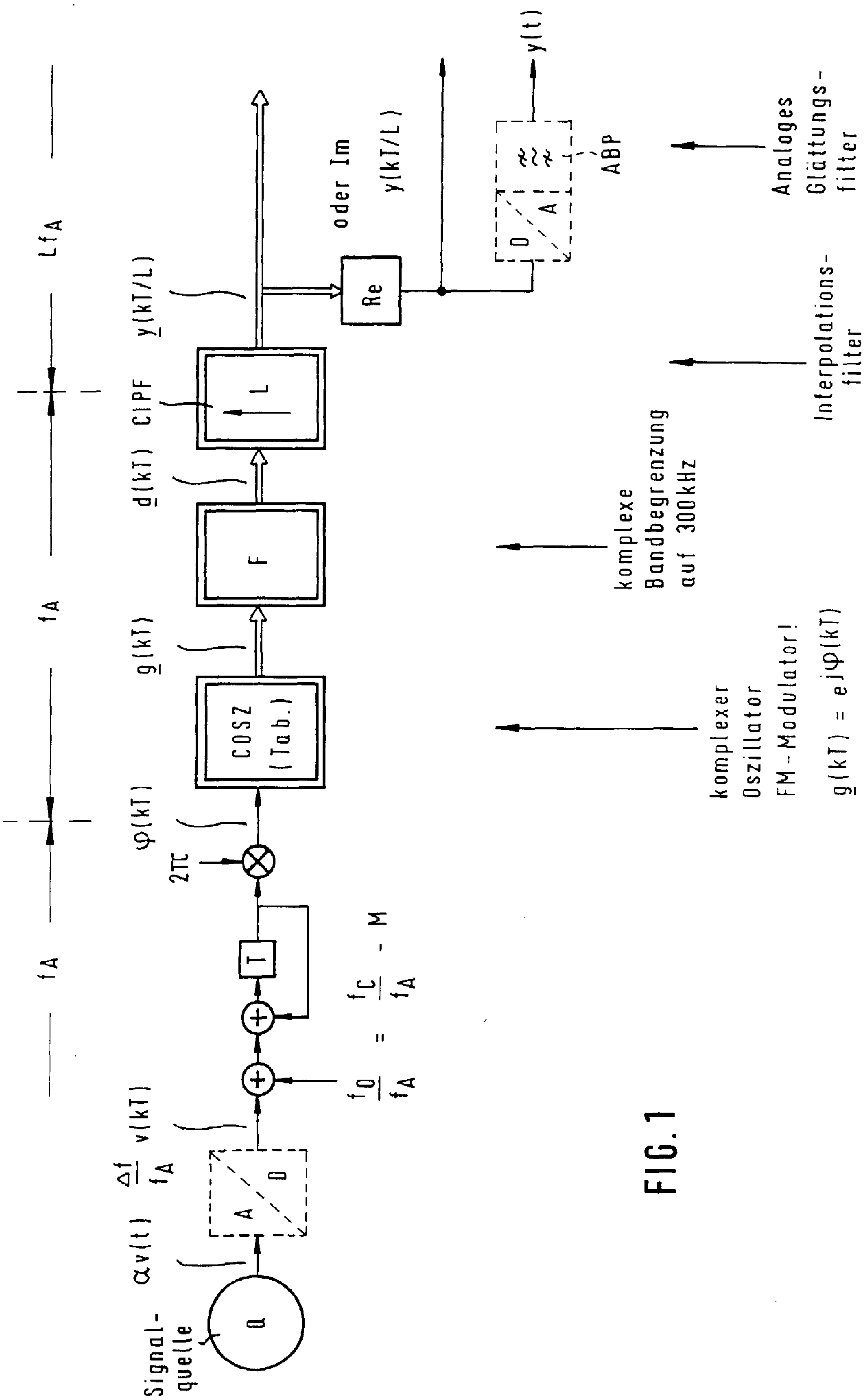
Signal-quelle
Q
αv(t)
A
D
Δf/fA
v(kT)
f0/fA
fC/fA - M
T
2π
φ(kT)
COSZ (Tab.)
g(kT)
F
d(kT)
CIPF
L
y(kT/L)
Re
oder Im
y(kT/L)
D
A
ABP
y(t)
fA
fA
LfA
komplexer Oszillator FM-Modulator!
g(kT) = ejφ(kT)
komplexe Bandbegrenzung auf 300kHz
Interpolations-filter
Analoges Glättungs-filter

FIG.1

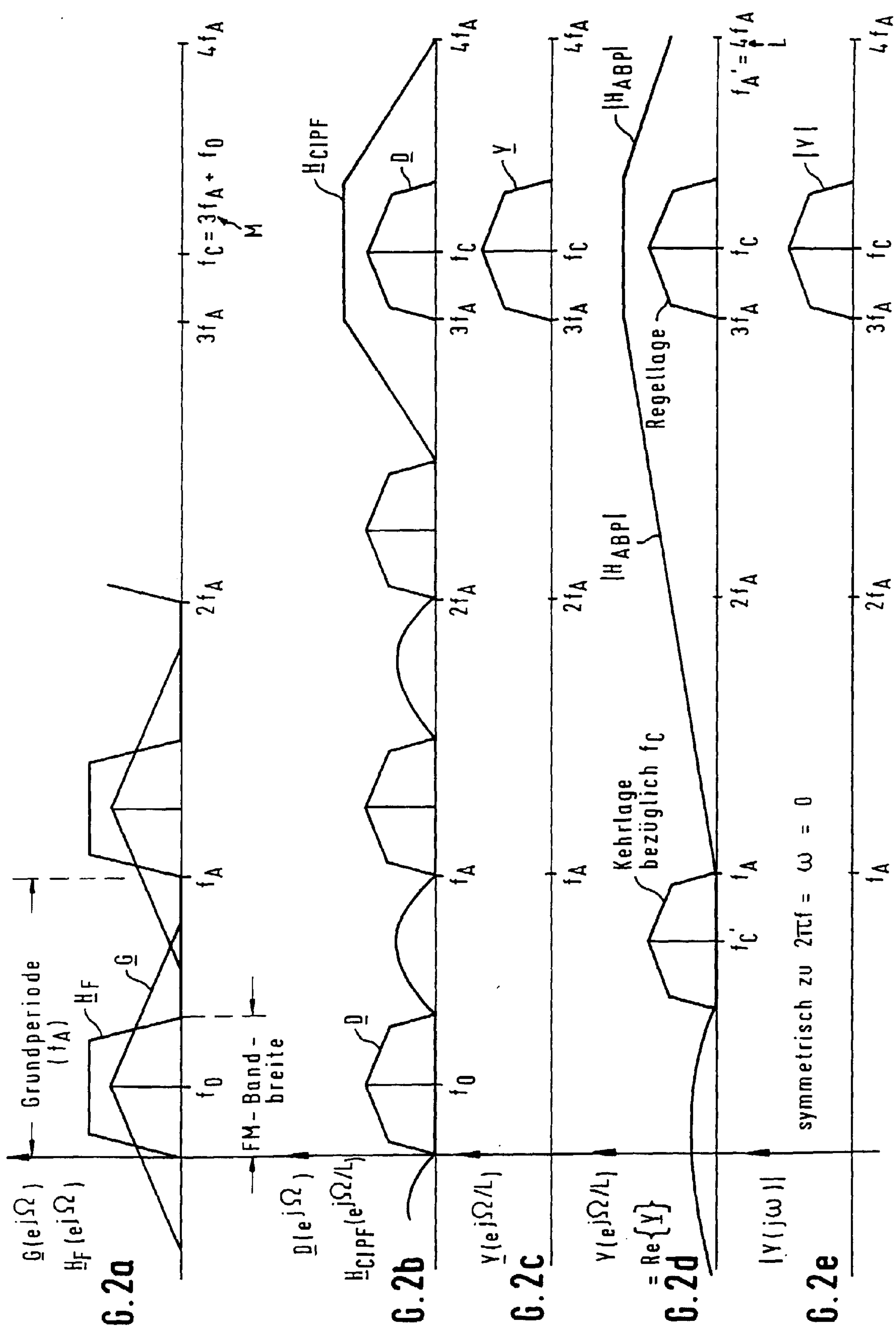


FIG. 2a

FIG. 2b

FIG. 2c

FIG. 2d

FIG. 2e

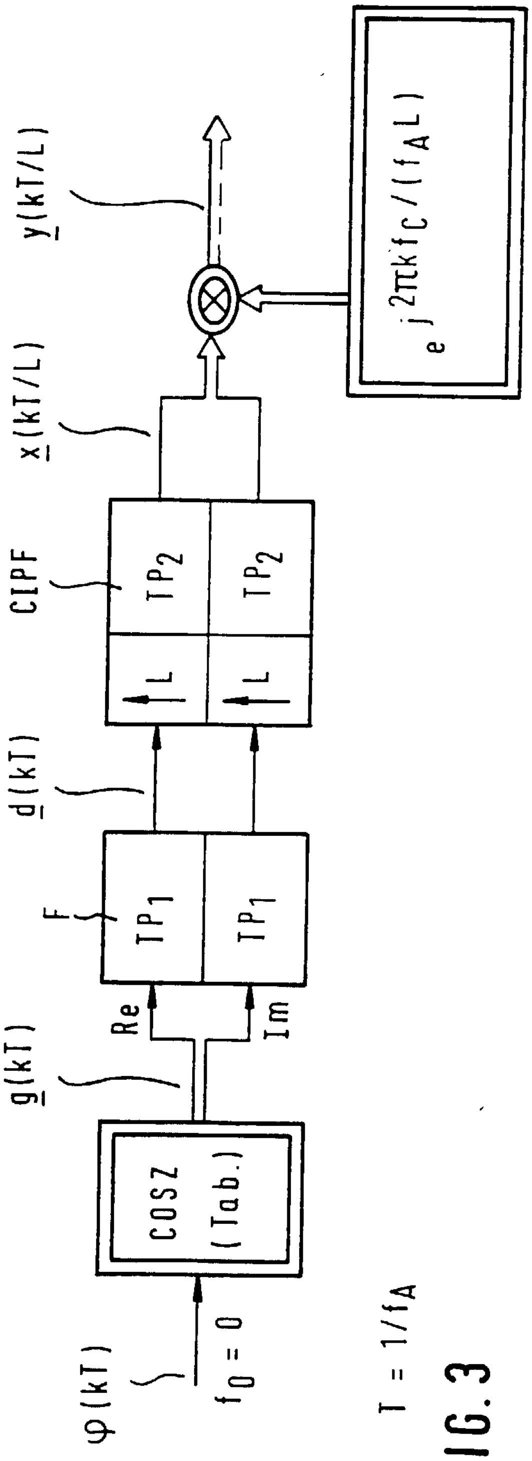
φ(kT)
$f_0 = 0$
COSZ (Tab.)
g(kT)
Re
Im
F
$TP_1$
$TP_1$
d(kT)
L
$TP_2$
CIPF
x(kT/L)
y(kT/L)
$e^{j2\pi k f_C/(f_A L)}$
$T = 1/f_A$

FIG. 3

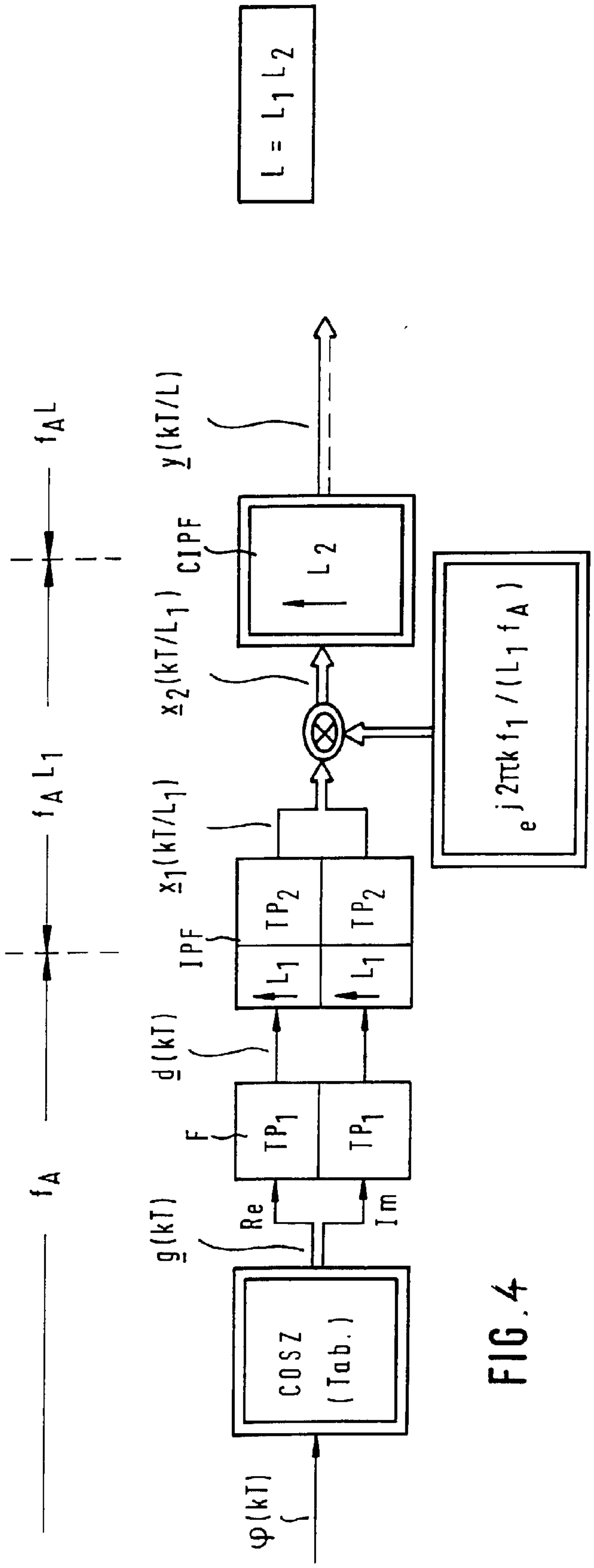
L = L1 L2
fA
fA L1
fA L
φ(kT)
COSZ (Tab.)
g(kT)
Re
Im
F
TP1
TP1
d(kT)
IPF
L1
L1
TP2
TP2
x1(kT/L1)
x2(kT/L1)
e j2πk f1 /(L1 fA)
CIPF
L2
y(kT/L)

FIG. 4

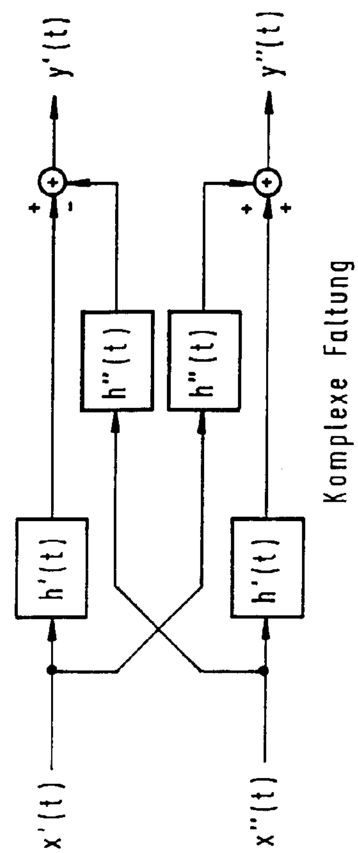
x'(t)
x''(t)
h'(t)
h'(t)
h''(t)
h''(t)
y'(t)
y''(t)
+
-
+
+
Komplexe Faltung

FIG. 5